# EUROPEAN PATENT SPECIFICATION

(11) **EP 0 351 413 B1**
(45) Date of publication and mention of the grant of the patent: **04.08.1993**
(21) Application number: 88902673.8
(22) Date of filing: 18.02.1988
(51) Int. Cl.: B05D 3/06, B29C 35/08, B29B 13/08

(54) **METHOD AND APPARATUS FOR PRODUCTION OF THREE-DIMENSIONAL OBJECTS BY PHOTOSOLIDIFICATION**
VORRICHTUNG UND VERFAHREN ZUR HERSTELLUNG DREIDIMENSIONALER GEGENSTÄNDE DURCH PHOTOVERFESTIGUNG
PROCEDE ET APPAREIL POUR LA PRODUCTION D'OBJETS TRIDIMENSIONNELS PAR PHOTOSOLIDIFICATION

(30) Priority: 02.03.1987 US 20764; 29.09.1987 US 102118
(43) Date of publication of application: 24.01.1990
(73) Proprietor: FUDIM, Efrem V., Milwaukee, WI 53217 (US)
(72) Inventor: FUDIM, Efrem V., Milwaukee, WI 53217 (US)
(74) Representative: Beneduce, Gianna
(86) International application number: US8800502
(87) International publication number: WO8806494

(56) References cited:
- JP-A-60 260 125
- SU-A- 626 967
- SU-A- 626 968
- US-A- 4 137 081
- US-A- 4 174 218
- US-A- 4 228 232
- US-A- 4 376 160
- US-A- 4 575 330
- Mechanical Engineering, Sept. 1985, Fudim, "A new method of three-dimensional micromachining", pages 54-59
- Machine Design, 6 March 1986, Fudim, "Sculpting parts with light", pages 102-106

## Description

This invention relates generally to improvements in a method and apparatus for rapid prototyping and production of three-dimensional (3D) objects. More specifically, it relates to forming 3D objects by the irradiation of photopolymers that solidify where irradiated, and of other radiation-sensitive materials whose irradiated portion can be rid of non-irradiated, or vice versa.

Commonly used processes for fabricating 3D objects have disadvantages. For example, the mechanical removal of material involves much energy, time and processing; the chemical machining has depth and geometry limitations and is very slow, and the thermal molding requires expensive molds, is very inflexible and takes much time and energy.

Several methods and apparatus have been developed for the production of 3D objects by irradiation of photopolymers. They form objects portion by portion employing irradiation means that irradiate according to desired configuration of each portion ("image"), photopolymer containing/support means to contain/support the photopolymer liquid, and object support means to keep in place the object as it is formed. Irradiation is accomplished by scanning point by point, either a sufficiently large volume of photopolymer with a pair of penetrating intersecting beams, or an exposed thin layer with a single laser beam when thin laminae are built successively one atop another. The irradiation is directed by a computer according to the 3D description ("solid model") of the object supplied by a computer-aided design (CAD) system. Such processes are complex, cannot be both fast and accurate since high fabrication speed requires a large beam while high resolution calls for a small beam, and consume too much energy due to high energy dissipation by small beams. They feature also warpage, especially of unsupported areas, due to solidification of an open unconstrained liquid, as well as shrinkage.

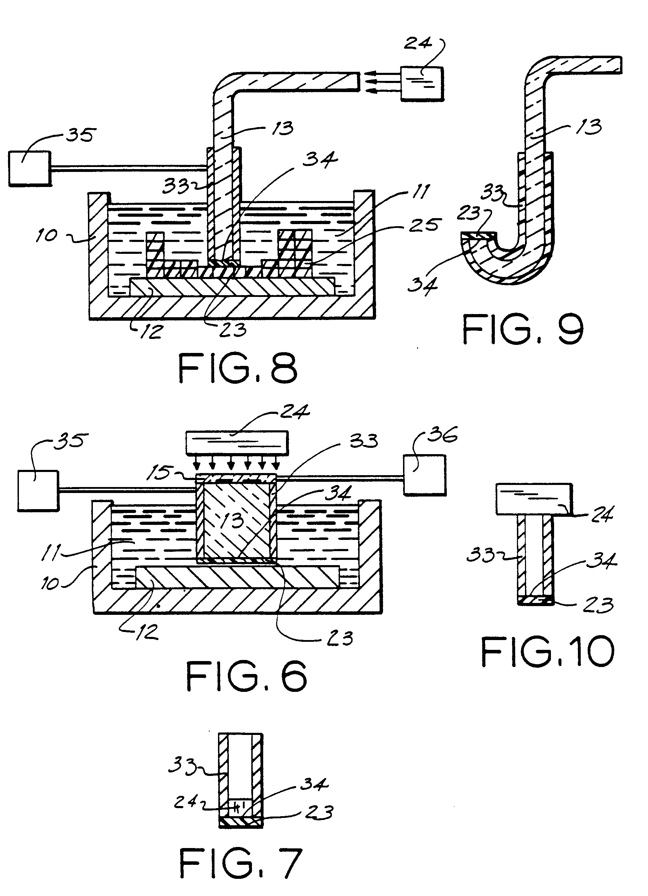

In an attempt to increase speed and accuracy, a system proposed in U.S. patent No. 4575330 on Figure 6 irradiates a whole layer simultaneously using a cathode-ray tube CRT. The CRT(39) is separated from the photopolymer with a thin water release layer (40) so that upon irradiation the CRT could be detached without damaging the object or CRT. However, water contaminates the photopolymer preventing attachment of subsequent layer. Also, due to photopolymer warpage during irradiation some areas bulge and expel the water while others sink and accumulate it; as a result, release is not achieved in bulging areas and the object is distorted especially in sinking areas. The process and apparatus of Figure 6 is not operational also because prescribed object movement away from CRT upon each irradiation will break the object or CRT. Furthermore, the system would not form objects since photopolymer irradiated through water will not attach to next layer since irradiation in water completes cross-linking.

Three-dimensional objects of various geometries are widely used everywhere in final products, prototypes and models. A large portion of such objects could be made of photopolymers by photosolidification if there were a suitable apparatus and method of producing these objects which resulted in dramatic reductions in cost and time and improvements in accuracy and performance characteristics.

The primary objects of the present invention are to provide an improved apparatus and method for making three-dimensional objects by the photosolidification of photopolymers, or by irradiation of other radiation-sensitive materials.

The preferred method of the present invention for generating three-dimensional objects from a photopolymer capable of solidification in response to radiation comprises providing a quantity of uncured photopolymer in a container. Contact means in a form of a rigid radiation transmittent plate, which has a bottom coating to which the solidified polymer will not adhere and which does not prevent the further cross-linking of the polymer, is placed in contact with the photopolymer. Next, an effective amount of photopolymer solidifying radiation is then transmitted through the plate into the uncured photopolymer, causing the photopolymer exposed to the light to solidify as a three-dimensional object. The thus obtained object of solidified polymer can be enlarged, if desired, by repeating the procedure, i.e., adding more photopolymer onto the object, repositioning the plate and repeating the irradiation.

By applying modulated radiation, complex three-dimensional objects can be formed during each procedure. But, the objects are limited in thickness or accuracy and can have only one layer of cavities.

To form more complex, thicker or more accurate objects, or to avoid the complicated modulation otherwise necessary in some cases, individual slices of an object are successfully built up one atop another. This is possible with the method of the present invention because the irradiated surfaces of the solidified photopolymer, which are in contact with the radiation transmittant plate, retain sufficient cross-linking capability after the initial irradiation and each subsequent slice automatically adheres to the preceding one to form combination objects. Since the irradiated surface retains further cross-linking capability, i.e. is not completely cross-linked or solidified, the plate can be easily separated without deforming the solidified photopolymer or the plate.

The simplest form of the novel apparatus of the present invention includes a container for the uncured photopolymer and irradiation means containing contact means made of a relatively rigid transparent plate adapted to rest upon the top surface of the uncured photopolymer, which plate has a bottom surface which does not interfere with the further cross-linking of the polymer and can be removed after irradiation; one or more masks to modulate radiation, which can be a part of the plate or a separate item; and a source of photopolymer solidifying radiation. The preferred apparatus also includes a removable substrate in the container upon which the solidified photopolymer can rest.

In another embodiment of the apparatus radiation is emitted directly into desired areas within the liquid photopolymer thus eliminating deposition of thin layers of liquid onto previously solidified layers.

In still another embodiment an array of miniature densely packed components that are individually controlled to provide necessary irradiation patterns is employed instead of mask. The array is preferrably in a form of a flat-panel display and its modulating components (pixels) are of generating type like light-emitting diodes LED or lasers, of transmission type (optical switches-shutters like liquid-crystal displays LCD), or of reflective type (mirrors).

In drawings which illustrate embodiments of the invention:
Figure 1 is a view, partly in section, of a preferred embodiment of the apparatus of the invention;
Figure 2 is a similar view of a second embodiment;
Fig. 3A is a schematic view of a multilayer object formed by the method of the invention;
Fig. 3B is a schematic view of an object formed by one embodiment of my method;
Fig. 4A and 4B are schematic views showing the use of a modulating radiation source;
Fig. 5 is a schematic view of an electric circuit board made by the method of the present invention;
Fig. 6 is a view of an embodiment in which radiation is emitted directly into desired areas within the liquid photopolymer;
Fig. 7 is a view of an embodiment of a radiation guide with a modulating radiation source positioned within the liquid in contact with the photopolymer layer to be irradiated;
Fig. 8 is a view, partly in section, of an embodiment for forming point by point and area-by-area;
Fig. 9 is a similar view of radiation guide emitting radiation upwards; and
Fig. 10 is a view of another embodiment (container and drive not shown).

The invention will now be described in connection with the drawings.

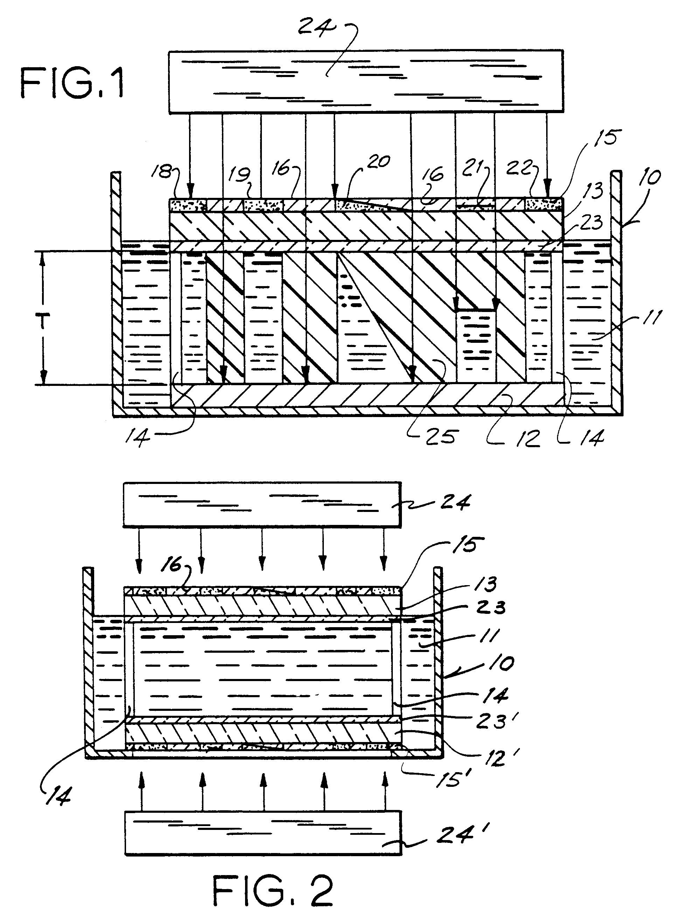

As seen in Fig. 1, a container 10 is partially filled with an uncured photopolymer 11 that solidifies when irradiated, preferrably with ultraviolet (UV) or similar radiation. Secured in the container 10 is a substrate 12. A radiation-transmitting, rigid plate 13 is supported on the top surface of the liquid photopolymer 11 by supports 14, only two of which can be seen. The distance between substrate 12 and plate 13 is equal to the desired thickness (T) of the object to be formed.

The plate 13 covers the top surface of the photopolymer 11 so no air is entrapped between the plate 13 and the top surface of the photopolymer 11. Plate 13 should be rigid enough to provide desired shape for the top surface of the polymer and to keep it unchanged during solidification. Plate 13 should preferrably not seal the container so that fluid volume changes resulting from solidification are made up by unrestricted supply of fluid from around the irradiated area. Resting on the top surface of the plate 13 is a mask 15 which has transparent areas 16 and areas of different opacity 18, 19, 20, 21 and 22. The bottom of the transparent plate, which is either glass or quartz, has a transparent coating 23 which does not substantially interfere with the ability of the photopolymer to further cross-link and can be removed after irradiation. Positioned above the mask 15 is a source of photopolymer solidifying radiation 24.

When it is desired to make a desired three-dimensional object with the described apparatus, radiation from the light source 24 is transmitted through the mask 15, plate 13 and coating 23 into the uncured photopolymer 11 to selectively solidify it and form a three-dimensional solid object 25 (seen in cross-section) which is adhered or attached to substrate 12.

The more radiant energy which is applied the greater is the depth of solidification. As is apparent from Fig. 1, no solidification occurs where the amount of energy is below a minimal value (e.g. below areas 18, 19 and 22); where the minimal amount of energy penetrates only to a partial depth, partial solidification occurs (e.g. below area 21); where the amount of energy changes abruptly from one value to another, a 90° wall is formed; and, where the amount of energy changes gradually, an inclined wall is created (e.g. below area 20).

In the simplest case of on-off irradiation, if an effective amount of radiation is applied to some areas while none or below the minimal amount to others, a planar object featuring exclusively through-holes and 90° walls is produced.

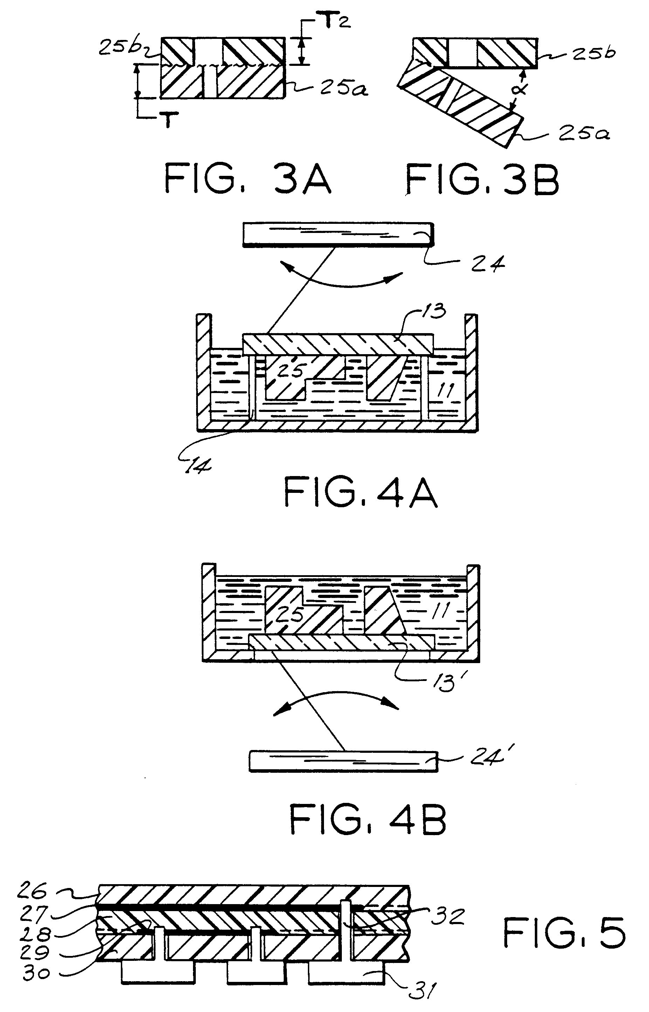

Additional layers are added to enlarge the object by removing the plate 13, adding more photopolymer on top of the object, replacing the same or a different plate 13 and selectively irradiating the uncured photopolymer to obtain an object as seen in Fig. 3A. This process can be repeated many times.

When the irradiation is complete, the plate 13 with its coating 23 and mask 15 are slid off and the solidified object 25, with or without the substrate 12 upon which it rests, are taken out of container 10. Excess unsolidified polymer 11 is removed using alcohol, water with detergent or other suitable solvent. The object 25 is dried, for example by using warm air jets, and subjected to additional irradiation, if necessary, to complete the cross-linking. The object 25 can be removed from the substrate 12 either before or after removing unsolidified photopolymer.

In the embodiment of Fig. 2 all the components are the same except for the substrate 12'. In this apparatus the substrate 12' is transparent and it has a coating 23' similar to 23. In addition, there is a second mask 15' and a second radiation source 24' positioned below the container so that the photopolymer can be irradiated from both above and below. With irradiation from the bottom and no coating 23' on plate 12, the apparatus of Fig. 2 can be used to build an object 25 similarly to the apparatus of Fig. 1.

The object 25 shown in Fig. 3B can be made by first making the bottom portion 25a, removing plate 13, turning substrate 12 with 25a attached clockwise by angle α, adding photopolymer, replacing plate 13 and irradiating to form portion 25b.

Although liquid photopolymer is preferred, almost any radiation-sensitive material that can have its irradiated portion rid of non-irradiated portion, or vice versa, can be used in the process. Usually, light-sensitive additives are used to reduce required energy. Common additives are benzophenore derivatives, quinones, benzol, benzoin ethers, and halogenated compounds. Photopolymer in sheet form also can be used instead of the liquid polymer. A preferred photopolymer liquid for use in the present invention is Magnacryl 2296 made by Beacon Chemical Company of Mount Vernon, New York.

A suitable radiation source is an assembly of General Electric lamps emitting UV light in the range of about 200 to about 500 nm, and preferably about 300 nm to about 400 nm, and providing intensity of several mw/cm² at the top surface of the photopolymer. Some photopolymers may require different wavelengths and/or radiation intensities. Mercury lamps, lasers, cathode ray tubes or other radiation sources, quartz or other radiation-transmitting materials and different automatically controlled actuators for scanning with an aperture or an optical fiber, also can be used. For high accuracy and resolution the radiation should be collimated.

The radiation source can also be one that scans (by deflecting the beams as in CRT or by moving the device 24 and/or container 10) and modulates. As seen in Fig. 4A and 4B, if such a radiation is used there is no need for a mask 15. Substrate 12 is not necessary when no layers have to be added on top of the object 25; the object will adhere to the plate 13. The thickness of the object will be determined by the amount of radiation applied to the top of plate 13 and can be less than the depth of the polymer. Alternatively, a mask can be used to modulate radiation, with or without a scanner, to prepare objects that have a thickness less than the depth of the polymer.

The substrate 12 can be of glass, plastic, stainless steel or any other material which will serve as a suitable support to which the solidified object will attach and will not displace when plate 13 is slid off. It can be opaque or transparent as in the case of substrate 12' in the embodiment of Fig. 2.

The plate 13 can be of any sufficiently rigid, radiation-transmitting material which should preferrably exclude air and prevent the surface of the cured photopolymer from forming other than desired shapes. The preferred plate 13 is of glass or similar rigid transparent material; however, it also can be a sufficiently rigid stretched transparent film which possesses the desired properties with or without a coating 23 (23') or just a film of material useful as coating 23. The plate 13 could also be a fused bundle of optical fibers (fiber optic faceplate) with one end of each fiber overlying the fluid and the other provided with an optical switch (shutter) controlling passage of radiation from a radiation source according to commands from a computer so that each fiber irradiates for a prescribed period of time and the top surface of the photopolymer is simultaneously irradiated with proper amount of energy. Currently available faceplates utilizing 8 µm diameter interstitial black fibers called EMA provide image resolution of 16 µm.

To modulate the radiation if a source of uniform radiation is used the mask 15 can be employed. The mask 15 may be of any functionally suitable material and it can be comprised of one or more components. The mask 15 may be a part of plate 13 or a separate item positioned preferrably between the plate 13 and coating 23. In a preferred embodiment, mask 15 is a metallic layer on the bottom of plate 13 and is made of microelectronic mask glass.

The transparent coatings 23, 23' can be any material which leaves the irradiated surface of the photopolymer capable of further cross-linking and to which the solidified polymer preferably does not adhere. The preferred material is fluorinated ethylene propylene copolymer, which is available as Teflon FEP in film, adhesive tape and other forms from du Pont of Wilmington, Delaware. It may be produced by the copolymerization of tetrafluorethelyne and hexafluoropropylene. Another resin that can be used is UHMW polyolefin available from CHR Industries of New Haven Connecticut as an adhesive tape. Other radiation transmitting materials that inhibit photopolymer cross-linking like those containing copper or oxygen can also be employed.

Apparatus where plate 13 seals the container are also possible in which case means are provided to allow free photopolymer flow to make up for shrinkage.

In still another embodiment no coating 23 is used in the apparatus of Fig. 1 if the substrate 12 is made of Teflon or other material the polymer does not adhere to. In this embodiment after irradiation the plate 13 with the object attached is slid off the substrate 12 inside the container.

Three-dimensional objects formed by the apparatus of the present invention can be used, in particular, as parts in integrated electric circuit boards. In such case, an insulating medium such as Magnacryl 2296, can be employed to form the structural portion, and the conducting layer can be deposited by metallization with subsequent mask etching, or by another process.

The method of the present invention also can be used to produce more complex objects by building separately a number of three-dimensional portions or slices, that have two surfaces which are capable of further cross-linking and attaching the slices together. They can be then joined by radiation. For best results, it should be done in the absence of oxygen and other inhibitors of crosslinking. The apparatus of the embodiment of Fig. 2 is useful for making such portions or slices as well as the apparatus of Fig. 1 when substrate 12 is made of Teflon or other material preserving cross-linking ability of the polymer. The apparatus of Fig. 4A and 4B having a plate 13, 13' with a coating 23, 23' also can be used.

Some of the slices or portions may be made from different polymers to provide different mechanical, electrical and other properties. By use of the novel method and apparatus of the present invention, valuable multilayer objects can be made such as integrated electric circuit boards (ECB). An example of such an ECB is shown in Fig. 5 in which 26 is an insulating layer, 27 is a conducting layer, 28 is another insulating layer, 29 is another conductor, 30 is another insulating layer, 31 are electrical components and 32 are pins in one or more slices of solidified photopolymer. Electrical components can be inserted before the desired portion or slice is formed, so that the components can get "soldered" at the time of solidification.

In the embodiment of Fig. 6 in addition to the components of Fig. 1, guide 33 and drives 35, 36 are employed. Plate 13 is preferably a fiberoptic faceplate that transmits the beam accurately from mask 15 to radiation emitting surface 34. Plate 13 is housed in guide 33 which is made of opaque material and isolates side surface of plate 13 from photopolymer both optically and hydraulically. Guide 33 is supported and positioned by drive 35. It is preferable that container 10 is initially filled to have enough photopolymer to form the whole object, and that guide 33 and plate 13 are of sufficient length. Drive 36 provides automated change of mask 15 from one irradiation step to another.

To make an object, plate 13 is immersed in photopolymer 11 so that a photopolymer layer of the thickness of the first layer to be formed is created between layer 23 and substrate 12, and proper radiation is applied. To form the second layer, plate 13 is slid off and repositioned, with proper alignment, so that its distance from substrate 12 is increased by the thickness of the second layer to be formed, mask 15 is changed, if necessary, and radiation reapplied. The procedure is repeated for successive layers. If required, additional photopolymer is added to keep the surface 34 from becoming exposed.

Masks 15 can be made in a form of a strip or roll of film where masks follow in the order of irradiation. Faceplate 13 can be of cross-section smaller than the object formed in which case slower fabrication area by area takes place. Instead of a mask, an array of miniature individually controlled mirrors or shutters like Texas Instruments' chip incorporating a million mirrors or a liquid-crystal flat-panel display can be employed to modulate irradiation of individual fibers of the faceplate 13. Mask 15 with radiation source 24 can be substituted also with a modulating radiation source that can provide different amounts of radiation to different fibers, such as a scanning radiation source that scans individual fibers of faceplate 13, or an array radiation source 24 that includes a number of individually controlled radiation sources (similar to LED displays) one per fiber or per cluster of fibers.

Fig. 7 shows an embodiment of guide 33 with a modulating radiation source 24 that fits inside radiation guide 33 and is mounted preferably adjacent to layer 23. No plate 13 is employed. Layer 23 can be provided with a radiation transmittant plate of glass or other suitable material for rigidity.

The embodiment of Fig. 8 has all the components of that of Fig. 6, except for the mask 15 and the drive 36. Plate 13 is a single fiber, or bundle, and its cross-section is small - of point size. When it is desired to make a three-dimensional object 25 with the described apparatus, layer 23 is positioned at a small distance from substrate 12, radiation from the light source 24 is transmitted through the optical fiber 13 and layer 23 into the uncured photopolymer 11 to solidify the photopolymer between layer 23 and substrate 12 (a "point") and to attach it to substrate 12. Guide 33 is then slid off, repositioned over the area on substrate 12 to be solidified next, and radiation reapplied. The procedure is repeated until the desired three-dimensional object is formed. Points can be solidified in different sequences; for some objects it can be done by layers.

Radiation source 24 can be mounted on top or inside of guide 33. Suitable optical fiber 13 is type Z from Applied Fiberoptics of Southbridge, Massachusetts. A suitable drive 35 is an XYZ-positioning stage or, for automated fabrication, an XYZ-positioning table with motors, motion controllers (all, for example, from Daedal Inc. of Harrison City, Pennsylvania) and computer. Container 10 or substrate 12 can also be provided with drives to take over some positioning from drive 35, to expedite fabrication for irradiation sequences requiring large displacements, e.g. Rotary motion can be used in addition or instead of linear motion. Instead of employing layer 23 that preserves cross-linking capability of irradiated photopolymer, guide 33 (or its irradiating tip) can be made of a material containing copper, oxygen or other ingredients that inhibit photopolymer cross-linking and thus preserve further cross-linking capability and let guide 33 be removed from the solidified photopolymer without distorting it.

Radiation guide 33 that irradiates upwards as shown in Fig. 9 or in any other direction can be used. Also, drive 35 that rotates guide 33 (or its irradiating tip), and thus modulates the space angle of irradiation emitting surface 34, can be employed, in particular, to increase fabrication accuracy of curved and inclined walls. Several guides 33, of same or different sizes and space angles of radiation emitting surface 34, can be used to irradiate different areas or to simultaneously irradiate same area from different sides. The latter is useful, for example, in making of thin walls and shells.

Guide 33 can be partially filled with radiation transmittant material or be hollow as shown in Fig. 10; it is sealed with a relatively rigid layer 23, and a laser or other radiation source 24 is attached. Radiation source 24 can also be mounted separately and connected to guide 13 with radiation-guiding optics, or, dimensions permitting, be mounted inside guide 33 over layer 23 as shown on Fig. 7.

When the cavity of guide 33 in Fig. 10 is of sufficiently small cross-section, such as one used for point by point irradiation, and is filled with air, oxygen or other radiation-transmittant inhibitor of cross-linking, or with alcohol or other solvent of the liquid photopolymer, layer 23 does not have to be employed, since the photopolymer will not enter the cavity, its further cross-linking capability is preserved, and guide 33 does not adhere to the solidified photopolymer. The cavity of guide 33 can be sealed hermetically or filled at its radiation source end with a transmittant material, for example, with optical fibers occupying all but the irradiation tip of the cavity.

Still other advantages and efficiencies of using my method in making such objects will be apparent to those skilled in the art.

Those skilled in the art will appreciate that the cross-linkable surfaces of objects made by the desired method lend themselves to easier deposition of electro-conductive layers by other manufacturing methods. For example, fine metal powders can be embedded into cross-linkable surfaces by use of jets through masks; the powders will then be permanently secured upon irradiation.

It also is to be understood that the objects made by the present invention can also include alien objects. The photopolymers readily adhere to many materials, therefore, objects can be formed in situ by irradiating a liquid photopolymer so it will solidify upon an existing part which serves in this case as the substrate. Special container design may be needed, depending on shape and access to existing assembly.

It further will be understood that porous objects can be made by creating pores in the object by proper use of modulated radiation with or without masks. The pores may be of differents sizes and spacing to effect the local density of the object.

Besides photopolymers, any radiation-sensitive material irradiated portion of which can be rid of non-irradiated portion, or vice versa, can be used in this invention.

While only several preferred embodiments have been shown and described herein, the invention is not intended to be limited thereby but only by the scope of the claims which follow.

## Claims

1. A method of preparing three-dimensional objects from uncured photopolymer (11) by treating the photopolymer with radiation to solidify the photopolymer, characterized in that the uncured photopolymer is irradiated through contact means (23) that is in contact with the photopolymer (11) and preserves the solidified photopolymer's ability to subsequently cross-link.

2. A method as claimed in Claim 1 wherein the following steps are performed:
(a) bringing into contact a quantity of an uncured photopolymer(11) and contact means (23),
(b) transmitting photopolymer solidifying radiation through the contact means (23) in an amount effective to cause the photopolymer to solidify to the desired extent and form a portion (25a) of the object,
(c) repeating step (a) for additional uncured photopolymer that is added to cover a previously formed portion (25a),
(d) transmitting photopolymer solidifying radiation through contact means (23) in an amount effective to cause the additional photopolymer to solidify to the desired extent to form a successive portion (25b) of the object, and to adhere to a previously formed portion (25a).

3. A method as claimed in Claim 1 wherein the following steps are performed:
(a) bringing into contact a quantity of an uncured photopolymer (11) and contact means (23),
(b) transmitting photopolymer solidifying radiation through contact means (23) in an amount effective to cause the photopolymer (11) to solidify to the desired extent and to form a portion of the object,
(c) repeating steps (a) and (b) for additional uncured photopolymer to form an additional portion of the object,
(d) bringing together the portions of the object along surfaces that are capable of further cross-linking, and irradiating the thus formed combination to join the portions together.

4. An apparatus for producing of three-dimensional objects from photopolymer comprising photopolymer support means and irradiation means for irradiating the photopolymer, characterized in that the irradiation means are provided with contact means (23) adapted to come into contact with the photopolymer, said contact means (23) preserving subsequent cross-linking capability of the irradiated photopolymer that is in contact with the contact means (23).

5. A method as claimed in Claim 1 wherein uncured phototopolymer is solidified by emitting radiation directly into a desired internal area within a quantity of photopolymer.

6. A method as claimed in Claim 5 wherein the following steps are performed:
(a) providing a quantity of uncured photopolymer,
(b) positioning contact means (23) within the quantity of uncured photopolymer in contact with the internal area to be irradiated,
(c) emitting photopolymer solidifying radiation through contact means (23) in an amount effective to cause the internal area to solidify to the desired extent,
(d) repeating steps (b) and (c) desired number of times to form subsequent portions of the object in desired sequence.

7. An apparatus as claimed in Claim 4 wherein contact means (23) is adapted to come into contact with desired internal area within a quantity of photopolymer and irradiate it area by area in desired sequence.

8. An apparatus for producing three-dimensional objects by irradiation of photopolymers comprising object support means for supporting the object as it is formed, and irradiation means, characterized in that the irradiation means contain an array of irradiating components each of which modulates irradiation of a portion of the photopolymer to provide in combination irradiation dictated by the configuration of the object.

9. An apparatus as claimed in Claim 8 wherein the array of irradiating components includes modulating sources of photopolymer solidifying radiation, components modulating transmittance of radiation, or components modulating reflectance of radiation.

10. A method of preparing three-dimensional objects from a photopolymer by treating the photopolymer with radiation to solidify the photopolymer area by area, characterized in that the amount of radiation applied to different areas of photopolymer varies according to the depth of solidification desired in each area.

11. Apparatus for producing three-dimensional objects from photopolymer comprising photopolymer support means and irradiation means for irradiating the photopolymer, characterised in that the irradiation means are means that provide different amounts of radiation to different areas of the photopolymer according to the depth of solidification desired in those areas.

12. A method as claimed in claims 1, 2, 3, 5, 6, 10 or 13 or apparatus as claimed in claims 4, 7, 8, 9, 11 or 13 wherein contact means (23) contains fluorinated ethylene propylene or another radiation transmitting material that preserves solidified photopolymer's ability to subsequently cross-link.

13. An apparatus as claimed in claims 4, 7, 8, 9, 11 or 12 or method as claimed in claims 1, 2, 3, 5, 6, 10 or 12 wherein other radiation-curable materials are employed instead of photopolymers.

## Patentansprüche

1. Verfahren zur Vorbereitung drei-dimensionaler Objekte aus ungesetztem Photopolymer (11), wonach das Photopolymer zur Verfestigung desselben mit Strahlung behandelt wird, dadurch gekennzeichnet, daß das ungesetzte Photopolymer durch ein Kontaktmittel angestrahlt wird (23), welches sich in Kontakt mit dem Photopolymer (11) befindet und die Fähigkeit des verfestigten Photopolymers aufrecht erhält, sukzessive Vernetzungen herzustellen.

2. Verfahren nach Anspruch 1, dadurch gekennzeichnet, daß die folgenden Schritte durchgeführt werden:
(a) Herstellung eines Kontaktes zwischen einer Menge ungesetzten Photopolymers (11) und eines Kontaktmittels (23),
(b) Durchlaß von Photopolymer verfestigender Strahlung durch das Kontaktmittel (23) und zwar in ausreichender Menge zur Verfestigung des Photopolymers zum gewünschten Grade, so daß das Photopolymer einen Teil (25a) des Objektes formt,
(c) Wiederholung von Schritt (a) mit zusätzlichem ungesetztem Photopolymer, das hinzugegeben wird, um ein vorher geformtes Teil (25a) zu bedecken,
(d) Durchlaß von Photopolymer verfestigender Strahlung durch das Kontaktmittel (23) und zwar in ausreichender Menge zur Verfestigung des zusätzlichen Photopolymers zum gewünschten Grade, so daß das Photopolymer einen sukzessiven Teil (25b) des Objektes bildet und an dem vorher geformten Teil (25a) haftet.

3. Verfahren nach Anspruch 1, dadurch gekennzeichnet, daß die folgenden Schritte durchgeführt werden:
(a) Herstellung eines Kontaktes zwischen einer Menge ungesetzten Photopolymers (11) und einem Kontaktmittel (23),
(b) Durchlaß von Photopolymer verfestigender Strahlung durch das Kontaktmittel (23) und zwar in ausreichender Menge zur Verfestigung des Photopolymers (11) zu dem gewünschten Grade, so daß das Photopolymer einen Teil des Objektes formt,
(c) Wiederholung der Schritte (a) und (b) mit zusätzlichem ungesetztem Photopolymer zum Zwecke der Formung eines weiteren Teiles des Objektes,
(d) Zusammenbringen von Objektteilen, die in der Lage sind weitere Vernetzungen herzustellen, entlang der Oberflächen, und Irradiation der somit geformten Kombination zur Zusammenbindung der einzelnen Teile.

4. Anordnung zur Herstellung drei-dimensionaler Objekte aus Photopolymer, bestehend aus Photopolymer-Unterstützungsmitteln sowie -Irradiationsmitteln, zum Zwecke der Anstrahlung des Photopolymers, dadurch gekennzeichnet, daß die Irradiationsmittel zusammen mit zur Kontaktherstellung mit den Photopolymer adaptierten Kontaktmitteln (23) geliefert werden, und wonach besagte Kontaktmittel (23) die spätere Fähigkeit des angestrahlten, mit dem Kontaktmittel (23) in Verbindung stehenden Photopolymers zur Herstellung von Vernetzungen aufrecht erhalten.

5. Verfahren nach Anspruch 1, dadurch gekennzeichnet, daß ungesetztes Photopolymer durch die direkte Emission von Strahlung auf den gewünschten inneren Bereich innerhalb einer Menge an Photopolymer verfestigt wird.

6. Verfahren nach Anspruch 5, dadurch gekennzeichnet, daß die folgenden Schritte durchgeführt werden:
(a) Bereitstellung einer Menge ungesetzten Photopolymers,
(b) Positionierung des Kontaktmittels (23) innerhalb der Menge ungesetzten Photopolymers und mit Verbindung zu dem inneren, zu bestrahlenden Bereich,
(c) Emission von Photopolymer verfestigender Strahlung durch das Kontaktmittel (23) und zwar in ausreichender Menge, so daß dies im gewünschten Verfestigungsgrad des inneren Bereiches resultiert,
(d) beliebig häufige Wiederholung der Schritte (b) und (c), so daß sukzessive Objektteile in der gewünschten Reihenfolge hergestellt werden.

7. Anordnung nach Anspruch 4, dadurch gekennzeichnet, daß das Kontaktmittel (23) dazu adaptiert wurde mit dem gewünschten inneren Bereich innerhalb einer Menge Photopolymers in Kontakt zu kommen und es, Bereich für Bereich, entsprechend der gewünschten Reihenfolge, anzustrahlen.

8. Erfindungsgemäß produziert die Anordnung drei-dimensionale Objekte durch die Irradiation von Photopolymeren, bestehend aus Objektunterstützungsmitteln zur Unterstützung des Objektes während des Formungsverfahrens, und Irradiationsmitteln, dadurch gekennzeichnet, daß die Irradiationsmittel eine Gruppierung von Irradiationskomponenten enthalten, von denen jedes einzelne die Irradiation eines Teiles des Photopolymers moduliert, um mit Hilfe einer kombinierten Zusammensetzung die anhand der Objektkonfiguration diktierte Irradiation herzustellen.

9. Anordnung nach Anspruch 8, dadurch gekennzeichnet, daß die Gruppierung der Irradiationskomponenten Modulationsquellen photopolymerfestsetzender Strahlung, strahlungstransmissionsmodulierender Komponenten oder rückstrahlungsmodulierender Komponenten enthält.

10. Verfahren zur Herstellung drei-dimensionaler Objekte aus Photopolymer, mit Hilfe derer Photopolymer zur bereichsweisen Verfestigung mit Strahlung behandelt wird, dadurch gekennzeichnet, daß die auf verschiedene Bereiche des Photopolymers angewandte Strahlungsmenge je nach der gewünschten Verfestigungstiefe jedes einzelnen Bereiches variiert.

11. Anordnung zur Herstellung drei-dimensionaler Objekte aus Photopolymer, bestehend aus Photopolymer-Unterstützungsmitteln und -Irradiationsmitteln zur Irradiation des Photopolymers, dadurch gekennzeichnet, daß die Irradiationsmittel Medien darstellen, die verschiedene Bereiche innerhalb des Photopolymers, je nach der gewünschten Verfestigungstiefe in einem gegebenen Bereich, unterschiedlichen Strahlungsmengen aussetzen.

12. Verfahren nach Anspruch 1, 2, 3, 5, 6, 10 oder 13 oder Anordnung nach Anspruch 4, 7, 8, 9, 11 oder 13, dadurch gekennzeichnet, daß das Kontaktmittel (23) fluoriniertes Äthylenpropylen oder ein anderes strahlungstransmittierendes Material enthält, welches die Fähigkeit des Photopolymers erhält, nach dessen Verfestigung spätere Vernetzungen einzugehen.

13. Anordnung nach Anspruch 4, 7, 8, 9, 11, oder 12 oder Verfahren nach Anspruch 1, 2, 3, 5, 6, 10 oder 12, dadurch gekennzeichnet, daß anstatt von Photopolymeren andere durch Strahlung setzungsfähige Materialien verwendet werden.

## Revendications

1. Méthode de préparation d'objets en trois dimensions par irradiation de photopolymère non cuit (11), caractérisée par le fait que le photopolymère non cuit est irradié par des moyens de contact (23) entrant en contact avec le photopolymère (11) et conservant les propriétés de réticulation du photopolymère solidifié.

2. Méthode selon la revendication 1, caractérisée par le fait que les opérations suivantes sont effectuées :
(a) mise en contact d'une certaine quantité de photopolymère non cuit (11) et des moyens de contact (23),
(b) à l'aide des moyens de contact (23), transmission de la radiation visant à solidifier le photopolymère, en quantité suffisante pour solidifier le photopolymère comme désiré et pour former une partie (25a) de l'objet,
(c) répétition de l'opération (a) pour le photopolymère supplémentaire ajouté pour recouvrir la partie déjà formée (25a),
(d) à l'aide des moyens de contact (23), transmission de la radiation visant à solidifier le photopolymère, en quantité suffisante pour solidifier le photopolymère comme désiré et pour former une nouvelle partie (25b) de l'objet, destinée à adhérer à la partie déjà formée (25a).

3. Méthode selon la revendication 1, caractérisée par le fait que les opérations suivantes sont effectuées :
(a) mise en contact d'une certaine quantité de photopolymère non cuit (11) et des moyens de contact (23),
(b) à l'aide des moyens de contact (23), transmission de la radiation, en quantité suffisante pour solidifier le photopolymère (11) comme désiré et pour former une partie de l'objet,
(c) répétition des opérations (a) et (b) avec du photopolymère afin de former une partie supplémentaire de l'objet,
(d) liaison des surfaces de l'objet qui sont capables de réticulation supplémentaire, et irradiation des combinaisons ainsi formées afin de souder les pièces ensemble.

4. Dispositif de fabrication d'objets en trois dimensions à partir de photopolymère, comportant des moyens de soutien et d'irradiation du photopolymère, caractérisé par le fait que les moyens d'irradiation sont fournis avec des moyens de contact (23) prévus pour entrer en contact avec le photopolymère. Lesdits moyens de contact (23) conservent les propriétés de réticulation du photopolymère irradié lorsqu'ils le touchent.

5. Méthode, selon la revendication 1, caractérisée par le fait que le photopolymère non cuit est solidifié par émission directe de radiation à l'intérieur d'une quantité donnée de photopolymère, dans une zone interne déterminée.

6. Méthode, selon la revendication 5, caractérisée par le fait que les opérations suivantes sont effectuées :
(a) prendre une quantité de photopolymère non cuit,
(b) les moyens de contact (23) du photopolymère non cuit sont mis au contact de la zone interne à irradier,
(c) une radiation visant à solidifier le photopolymère est émise grâce aux moyens de contact (23) en quantité suffisante pour solidifier la zone interne comme désiré,
(d) les opérations (b) et (c) sont répétées autant de fois qu'il sera nécessaire afin de former les autres parties de l'objet dans l'ordre voulu.

7. Dispositif, selon la revendication 4, caractérisé par le fait que les moyens de contact (23) sont adaptés pour entrer en contact avec la zone interne du photopolymère et pour l'irradier zone par zone dans l'ordre voulu.

8. Dispositif de fabrication d'objets en trois dimensions par irradiation de photopolymère, comportant des moyens d'irradiation et des moyens de soutien de l'objet afin de le soutenir lors de la fabrication, caractérisé par le fait que les moyens d'irradiation comportent des éléments modulant l'irradiation d'une partie du photopolymère afin de fournir une combinaison d'irradiation correspondant à la configuration de l'objet.

9. Dispositif, selon la revendication 8, caractérisé par le fait que les composants de l'irradiation comportent des sources de modulation de la radiation, des éléments modulant la transmission de la radiation ou des éléments modulant la réflexion de la radiation.

10. Méthode de préparation d'objets en trois dimensions, par irradiation d'un photopolymère afin de le solidifier zone par zone, caractérisée par le fait que la quantité de radiation utilisée dans les différentes zones du photopolymère varie selon la profondeur de solidification désirée pour chaque zone.

11. Dispositif de fabrication d'objets en trois dimensions à partir de photopolymère, comportant des moyens de soutien de l'objet et des moyens d'irradiation du photopolymère, caractérisé par le fait que les moyens d'irradiation fournissent différentes quantités de radiation à différents endroits du photopolymère selon la profondeur de solidification désirée à ces endroits.

12. Méthode, selon les revendications 1, 2, 3, 5, 6, 10 ou 13, ou dispositif, selon les revendications 4, 7, 8, 9, 11 ou 13 caractérisés par le fait que les moyens de contact (23) contiennent de l'éthylène-propylène fluoré ou un autre moyen de transmission de la radiation conservant les propriétés de réticulation du photopolymère solidifié.

13. Dispositif, selon les revendications 4, 7, 8, 9, 11 ou 12, ou méthode, selon les revendications 1, 2, 3, 5, 6, 10 ou 12, caractérisés par le fait que d'autres matériaux pouvant être cuits par radiation sont utilisés à la place de photopolymères.
